(19) Europäisches Patentamt
European Patent Office
Office européen des brevets

(11) Veröffentlichungsnummer: **0 062 839**
**B1**

(12) # EUROPÄISCHE PATENTSCHRIFT

(45) Veröffentlichungstag der Patentschrift: **21.11.84**

(21) Anmeldenummer: **82102700.0**

(22) Anmeldetag: **31.03.82**

(51) Int. Cl.³: **C 07 F 9/40**, C 07 F 9/30, C 07 F 9/36, C 08 F 2/50, C 08 K 5/53, G 03 C 1/68, G 03 F 1/02

(54) **Acylphosphinverbindungen und ihre Verwendung.**

(30) Priorität: **09.04.81 DE 3114341**

(43) Veröffentlichungstag der Anmeldung: **20.10.82 Patentblatt 82/42**

(45) Bekanntmachung des Hinweises auf die Patenterteilung: **21.11.84 Patentblatt 84/47**

(84) Benannte Vertragsstaaten: **AT BE CH DE FR GB IT LI NL SE**

(56) Entgegenhaltungen:
**EP - A - 0 007 508**
**EP - A - 0 009 348**
**DE - A - 2 830 927**

**Die Akte enthält technische Angaben, die nach dem Eingang der Anmeldung eingereicht wurden und die nicht in dieser Patentschrift enthalten sind.**

(73) Patentinhaber: **BASF Aktiengesellschaft, Carl-Bosch-Strasse 38, D-6700 Ludwigshafen (DE)**

(72) Erfinder: **Henne, Andreas, Dr., Bruesseler Ring 34, D-6700 Ludwigshafen (DE)**
Erfinder: **Hesse, Anton, Dr., Peter-Nickel-Strasse 15, D-6940 Weinheim (DE)**
Erfinder: **Jacobi, Manfred, Dr., Heidelberger Ring 32B, D-6710 Frankenthal (DE)**
Erfinder: **Wallbillich, Guenter, Dr., Eichendorffallee 15, D-6707 Schifferstadt (DE)**
Erfinder: **Bronstert, Bernd, Dr., Zanderstrasse 35, D-6701 Otterstadt (DE)**

EP 0 062 839 B1

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

**Beschreibung**

Die vorliegende Erfindung betrifft neue Acylphosphinverbindungen und ihre Verwendung als Photoinitiatoren in photopolymerisierbaren Massen, wie Überzugsmitteln, Lacken, Druckfarben, ungesättigte Polyesterformmassen, Aufzeichnungsmaterialien sowie in photopolymerisierbaren wasserhaltigen Gemischen, wie wäßrige Polymerisat-Dispersionen oder Polymerisat-Lösungen.

Es sind bereits eine Reihe von Photoinitiatoren verschiedener Strukturen bekannt, z. B. Benzilketale (DE-PS 2 261 383), Benzoinether (DE-AS 1 694 149), Thioxanthon (DE-OS 2 003 132). Photopolymerisierbare Massen, die mit derartigen Initiatorsystemen gehärtet werden, zeigen jedoch eine unerwünschte Vergilbung, die eine Verwendung dieser Systeme auf hellen Flächen oder zur Härtung von transluzenten Formteilen nicht zuläßt. Ein weiterer Nachteil der genannten Verbindungsklassen sowie auch der als Photoinitiatoren beschriebenen Acylphosphinoxide (DE-OS 2 830 927, DE-OS 2 909 994) ist die oft ungenügende Lagerstabilität der fertig sensibilisierten Harzmischungen, die trotz Dunkellagerung häufig nur einige Tage haltbar sind. Dieser Nachteil kennzeichnet auch die in US-PS 3 668 093 beschriebenen Acylphosphinderivate, die bereits durch Feuchtigkeit und Luft zersetzt werden und überdies zu starker Vergilbung der damit hergestellten Photopolymerisate führen. Außerdem besteht ein Bedarf an Initiatoren, die den oben genannten Verbindungsklassen in ihrer Härtungsaktivität überlegen sind.

Für die Photopolymerisation von wasserhaltigen Gemischen werden Photoinitiatoren benötigt, die in Wasser eine Löslichkeit von etwa 1 bis 3% besitzen. Solche Verbindungen sind z. B. die in DE-OS 2 831 263 beschriebenen Benzoinderivate mit quartärer Ammoniumgruppe. Es besteht jedoch ein Bedarf an wasserlöslichen Photoinitiatoren, die längerwellig absorbieren und eine höhere Aktivität als die dort beschriebenen Verbindungen besitzen.

Ziel der vorliegenden Erfindung ist es, Verbindungen bereitzustellen, die längerwellig absorbieren und somit durch Einsatz ungefährlicherer Lichtquellen oder durch Sonnenlicht gehärtet werden können, als die aus der DE-OS 2 831 263 bekannten Verbindungen; ein weiteres Ziel ist es, Verbindungen aufzuzeigen, die eine höhere Härtungsaktivität haben und eine höhere Lagerstabilität der fertig sensibilisierten Harzmischungen ermöglichen, als die aus DE-OS 2 830 927 und DE-OS 2 909 994 bekannten Acylphosphinoxide.

Gegenstand der vorliegenden Erindung sind Acylphosphinverbindungen der allgemeinen Formel (I)

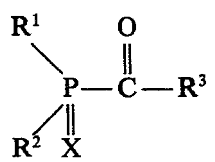

(I)

wobei die Substituenten folgende Bedeutung haben:

$R^1$ ist gleich $R^4$ oder $OR^4$,

$R^2$ steht für die Gruppierungen $-O^-M^+$ oder $-NR^5R^6$, wobei ein $M^+$ ein Äquivalent eines Kations der 1. bis 3. Hauptgruppe des Periodensystems mit einem Atomgewicht unter 138 oder der Ammoniumionen

$$^{\oplus}NR^5R^6R^7R^8 \quad (II)$$

oder

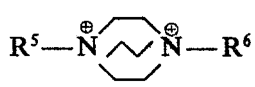

(II')

bedeutet, wobei $R^5$ bis $R^8$ gleich oder verschieden sind und für Wasserstoff, einen geradkettigen oder verzweigten Alkylrest mit bis zu 18 C-Atomen, die gegebenenfalls durch eine Hydroxylgruppe substituiert sein können, für den Cyclohexyl-, Cyclopentyl-, Allyl- oder Phenylrest oder die $\beta$-(Meth)Acryloxyethylgruppe stehen, oder in der Formel II zwei dieser Substituenten zusammen mit dem Stickstoff einen 5- bis 7gliedrigen Ring bilden, der gegebenenfalls ein Sauerstoff- oder ein weiteres Stickstoffatom enthalten kann,

$R^3$ ist ein substituierter Phenyl-, Naphthyl-, Pyridyl-, Pyrrolyl-, Furyl- oder Thienylrest, der zumindest an den beiden zur Verknüpfungsstelle mit der Carbonylgruppe benachbarten Kohlenstoffatomen Substituenten trägt, die gleich oder verschieden sein können, und die bis zu 6 Kohlenstoffatome enthaltende, geradkettige oder verzweigte Alkyl-, Alkoxy- oder Alkylthio-Reste, bis zu 7 Kohlenstoffatome enthaltende Cycloalkyl- oder Phenylreste, Nitril-, Carboxyl-, Carboalkoxygruppen oder die Halogenatome, Fluor, Chlor oder Brom sein können,

$R^4$ steht für Wasserstoff, einen geradkettigen oder verzweigten Alkyl- oder Alkenyl-Rest mit bis zu 8 Kohlenstoffatomen, welcher gegebenenfalls durch die Gruppierung $-NR^5R^6$ substituiert sein kann, den Cyclohexyl- oder Cyclopentyl-Rest oder einen gegebenenfalls bis zu dreifach substituierten Phenylrest, wobei die Substituenten geradkettige oder verzweigte, bis zu 6 Kohlenstoffatome enthaltende Alkyl-, Alkoxy-, Alkylthio- oder $NR^5R^6$-Gruppen oder die Halogenatome Fluor, Chlor oder Brom sein können;

X steht für Sauerstoff oder Schwefel oder bedeutet ein freies Elektronenpaar am Phosphor.

Ein weiterer Gegenstand der Erfindung ist die Verwendung von Acylphosphinverbindungen der allgemeinen Formel I als Photoinitiatoren in photopolymerisierbaren Massen, z. B. für Überzugsmittel, Lacke, Druckfarben und Aufzeichungsmaterialien, in Formmassen auf Basis ungesättigter Polyesterharze sowie zur Photopolymerisation wäßriger Lösungen, Dispersionen und Emulsionen.

Acylphosphinoxidverbindungen ähnlicher Art, ihre Herstellung und ihre Verwendung als Pflanzenbehandlungsmittel sind in der EP-OS 9 348 beansprucht, jedoch ist dort keine der durch das spezielle Substitutionsmuster in $R^3$ gekennzeichneten Verbindungen der vorliegenden Erfindung beschrieben, ferner enthält die EP-OS 9 348 keine Hinweise auf die Verwendbarkeit der dort beschriebenen Verbindungen als Photoinitiatoren.

Bezüglich der allgemeinen Formel I der erfindungsgemäßen Acylphosphinverbindungen ist im einzelnen folgendes auszuführen:

$R^3$ ist vorzugsweise ein Phenylrest, der mindestens an den beiden zur Verknüpfungsstelle mit der Carbonylgruppe benachbarten Kohlenstoffatomen substituiert ist, es kann ferner ein entsprechend substituierter Naphthyl-, Furyl-, Thienyl-, Pyrrolyl- und Pyridylrest sein. Bevorzugt ist $R^3$ ein 2,6-Dimethylphenyl-, 2,6-Dimethoxyphenyl-, 2,6-Dichlorphenyl-, 2,6-Dibromphenyl-, 2-Chlor-6-methoxyphenyl-, 2-Chlor-6-methylthio-phenyl-, 2,4,6-Trimethylphenyl-, 2,4,6-Trimethoxyphenyl-, 2,3,5,6-Tetramethylphenyl-, 2,6-Dimethyl-4-tert.-butylphenyl-, 1,3-Dimethylnaphthalin-2-, 2,8-Dimethylnaphthalin-2-, 1,3-Dimethoxynaphthalin-2-, 1,3-Dichlornaphthalin-2-, 2,8-Dimethoxynaphthalin-1-, 2,4,6-Trimethylpyridin-3-, 2,4-Dimethoxyfuran-3- oder ein 2,4,5-Trimethylthiophen-3-Rest.

X kann stehen für Sauerstoff, Schwefel oder ein freies Elektronenpaar am Phosphoratom; bevorzugt ist X Sauerstoff.

$R^2$ ist $-O^{-}M^{\oplus}$ oder $-NR^5R^6$.

$M^{\oplus}$ steht für ein Äquivalent eines Kations der 1. bis 3. Hauptgruppe des Periodensystems, wie z. B. Wasserstoff, Lithium, Natrium, Kalium, Magnesium, Calcium, Barium und Aluminium oder eines Ammoniumions der allgemeinen Formeln

$$N^{\oplus}R^5R^6R^7R^8 \qquad (II)$$

oder

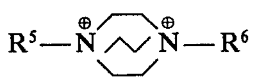

(II')

Beispiele für solche Ammoniumionen sind: Ammonium-, Triethylammonium-, Tributylammonium-, Tetramethylammonium-, Tetraethylammonium-, Methyldiethanolammonium-, Anilinium-, N,N-Dimethylanilinium-, $\beta$-Acryloxyethyldiethylammonium-, $\beta$-Acryloxyethyl-diethylammonium-, N-($\beta$-Hydroxyethyl)-morpholinium-Ionen sowie das zweiwertige 1,4-Diaza[2.2.2]-bicyclooctan-Dikation (II').

$R^4$ kann z. B. Wasserstoff sein oder ein Methyl-, Ethyl-, iso-Propyl-, n-Butyl-, sec.-Butyl-, iso-Butyl-, t-Butyl-, Amyl-, n-Hexylrest; ein Vinyl-, 2-Methylvinyl-, 2-Propenylrest; ein 2-Dimethylaminoethyl-, ein 3-Dimethylaminopropylrest; ein Cyclohexyl-, Cyclopentyl-, ein Phenyl-, ein halogensubstituierter Phenylrest, wie Mono- oder Dichlorphenyl-; ein $C_1$- bis $C_4$-alkylsubstituierter Phenylrest, wie z. B. ein Methylphenyl-, Ethylphenyl-, Isopropylphenyl-, tert.-Butylphenyl-, Dimethylphenyl-, Trimethylphenyl-, $C_1$- bis $C_4$-alkoxysubstituierter Phenylrest, wie z. B. ein Methoxyphenyl-, Ethoxyphenyl-, Dimethoxyphenyl rest.

Beispiele für bevorzugte Acylphosphin-Verbindungen sind:

2,4,6-Trimethylbenzoylphosphinsäuremonomethylester,
2,4,6-Trimethylbenzoylmethylphosphinsäure,
2,6-Dimethoxybenzoylmethylphosphinsäure,
2,4,6-Trimethylbenzoyl-n-butylphosphinsäure

und die Salze dieser Säuren mit den oben genannten Kationen.

Als Beispiele für besonders bevorzugte Verbindungen seien genannt:

2,4,6-Trimethylbenzoylphenylphosphinsäure und ihre Li-, Na-, K-, Ca-, Ba-, Mg-, Al-, Triethylammonium-, Methyldiethanolammonium-, Tributylammonium-, $\beta$-Acryloxyethyldiethylammonium-, Anilinium-, Dimethylamänilinium-Salze sowie das 1,4-Diazabicyclo[2.2.2]octan-Salz, 2,4,6-Tri-

methylbenzoyl(o-tolyl)-phosphinsäure, 2,4,6-Trimethylbenzoyl(p-tolyl)-phosphinsäure, 2,6-Dimethoxybenzoylphenylphosphinsäure, 2,6-Dichlorbenzoylphenylphosphinsäure, 2,6-Dimethylbenzoylphenylphosphinsäure sowie die Salze dieser Säuren mit den oben bezeichneten Kationen, 2,6-Dimethoxybenzoylphenylphosphinsäuredimethylamid.

Bei einem der Verfahren zur Herstellung der erfindungsgemäßen Verbindungen wird eine Acylphosphinverbindung der allgemeinen Formel (III) in einem polaren Lösungsmittel bei einer Temperatur zwischen 0 und 150°C mit einem Metallhalogenid $M^{\oplus}Y^{\ominus}$ umgesetzt.

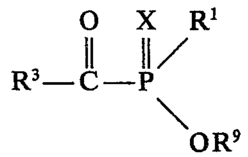

(III)

Dabei haben $R^1$, $R^3$, $M^{\oplus}$ und X die vorhergenannten Bedeutungen, $R^9$ ist ein verzweigter oder geradkettiger Alkylrest mit 1 bis 6 C-Atomen, vorzugsweise eine Methylgruppe; Y ist ein Fluorid-, Chlorid-, Bromid- oder vorzugsweise Jodid-Ion. Als polare Lösungsmittel eignen sich Alkohole wie Methanol, Ethanol, Nitrile wie Acetonitril, Benzonitril, Sulfoxide wie Dimethylsulfoxid, Tetramethylensulfon, Ether wie Tetrahydrofuran oder vorzugsweise Ketone wie Aceton oder Methylethylketon. Zur Erhöhung der Löslichkeit des Metallhalogenids MX können dem Lösungsmittel bis 0.2 Mol/Mol Metallsalz eines Phasentransferkatalysators oder eines Kronenethers zugesetzt werden.

Bei einer bevorzugten Ausführung der Reaktion löst sich das Salz MY und die Phosphinverbindung der Formel (III) im Lösungsmittel. Die Acylphosphinverbindung der Formel (I) fällt sofort oder nach Erhitzen aus und kann abfiltriert und ggf. durch die dem Fachmann bekannten Verfahren weiter gereinigt werden:

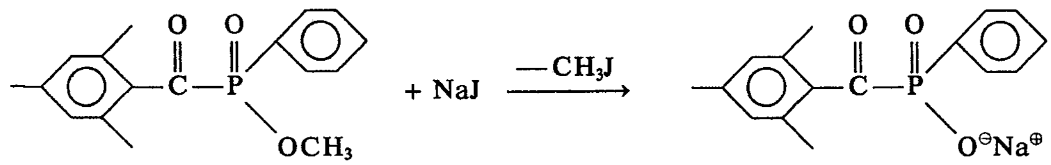


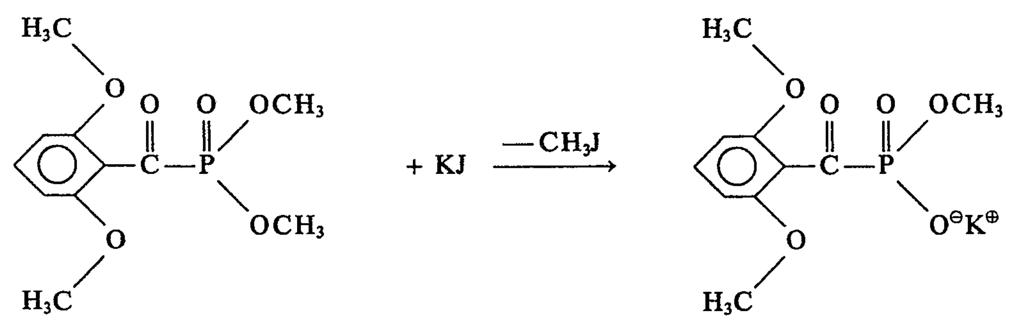


Die Ausgangsverbindung der allgemeinen Formel (III) ist z. B. nach DE-OS 2 909 994 ($R^1=R^4$) oder auf bekanntem Weg ($R^1=OR^4$, s. R. S. Marmor und D. Seyferth, J. Organ. Chemistry 36, 128, 1971) zugänglich. Bevorzugt ist der Einsatz solcher Verbindungen der allgemeinen Formel (III) in denen $R^9$ für die Methylgruppe steht, da diese bei der Umsetzung mit dem Metallhalogenid MY besonders rasch reagieren.

Bei einem weiteren Verfahren zur Herstellung der Verbindung der allgemeinen Formel (I) wird aus einem Metallsalz der Formel (IV)

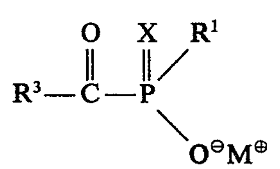

(IV)

durch Umsatz mit einem Metallsalz der Formel $M^{\oplus}Z^{\ominus}$ in einem polaren Lösungsmittel, das gewünschte Metallsalz der Formel (I) hergestellt. Dabei haben $R^1$, $R^3$ und $M^{\oplus}$ die vorher beschriebene Bedeutung; $M^{\oplus *}$ hat die gleiche Bedeutung wie $M^{\oplus}$, ist jedoch von $M^{\oplus}$ verschieden, und $Z^{\ominus}$ steht für ein Äquivalent eines beliebigen Anions. Geeignete polare Lösungsmittel für die Umsetzung sind oben genannt, ein bevorzugtes Lösungsmittel ist Wasser. Dieses Verfahren der Herstellung wird bevorzugt dann angewandt, wenn sich sowohl das Salz der Formel (IV) wie die Salze $M^{\oplus}Z^{\ominus}$ und $M^{\oplus *}Z^{\ominus}$ im gewählten Lösungsmittel

gut, das gewünschte Salz der Formel (I) jedoch nur schlecht löst. Das gewünschte Metallsalz der Formel (I) fällt dann beim Zusammengeben der Lösungen von $M^{\oplus}Z^{\ominus}$ und dem Salz der Formel (IV) aus und kann gegebenenfalls nach den dem Fachmann bekannten Verfahren weitergereinigt werden.

Folgende Gleichungen beschreiben dieses Verfahren beispielhaft:

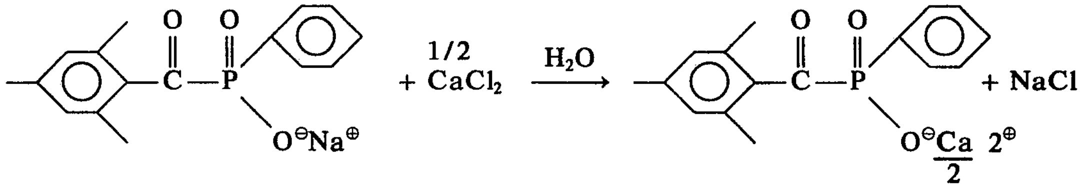


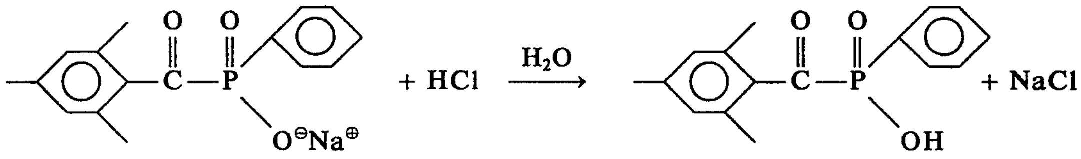


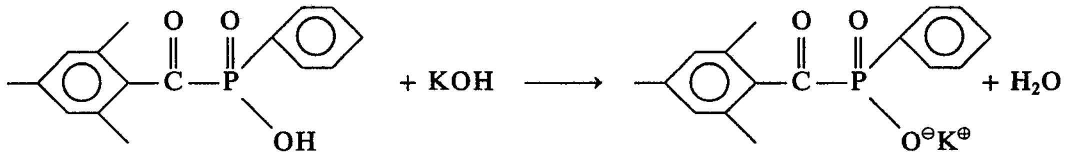


Ein drittes Verfahren liefert die Ammoniumsalze der Formel (I), indem eine Phosphinsäure oder ein Phosphonsäureester der Formel (V)

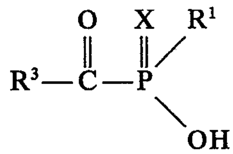

(V)

mit stöchiometrischen Mengen eines Amins der Formel (VI)

$$NR^5R^6R^7 \qquad (VI)$$

wobei $R^1$, $R^3$, X, $R^5$, $R^6$ und $R^7$ die vorher beschriebene Bedeutung haben, bei Temperaturen zwischen 0 und 100°C ohne Lösungsmittel oder in einem polaren oder unpolaren Lösungsmittel wie Methanol, Aceton, Methylenchlorid, Toluol, Acetonitril oder Tetrahydrofuran umgesetzt wird und das Lösungsmittel anschließend destillativ entfernt wird.

Die folgenden Beispiele beschreiben diese Umsetzung:

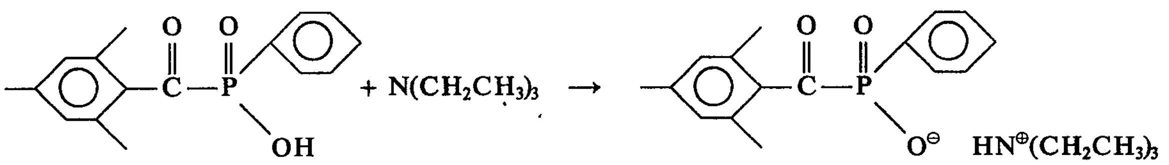


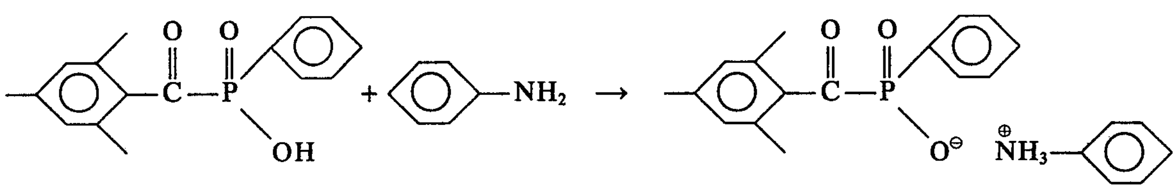

Beispiele für die erfindungsgemäßen Verbindungen sind, ohne dies als Beschränkung zu sehen, insbesondere folgende in Tabelle 1 zusammengestellte Verbindungen der allgemeinen Formel (I) mit X=O.

**Tabelle 1**

| Nr. | Verbindung (Ph = Phenyl)<br>$R^3$ | $R^1$ | $R^2$ | Herstell-<br>verfahren | Aus-<br>beute<br>in % | Analyse | C | H | P | M | Schmp. |
|---|---|---|---|---|---|---|---|---|---|---|---|
| 1 | 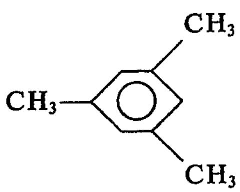 | $OCH_3$ | ONa | I | 94 | ber.<br>gef. | 50,0<br>47,0 | 5,3<br>5,4 | 11,7<br>11,2 | 8,71<br>8,3 | > 280° |
| 2 | desgl. | $OCH_3$ | OH | II<br>aus Verb. 1 | | ber.<br>gef. | | | | | 303–306° |
| 3 | desgl. | $OCH_3$ | OLi | I | 95 | ber.<br>gef. | 53,23<br>48,9 | 5,65<br>5,9 | 12,5<br>12,2 | 2,82<br>n. b. | > 270° |
| 4 | desgl. | Ph | ONa | I | 100 | ber.<br>gef. | 61,9<br>60,7 | 5,2<br>5,4 | 10,0<br>9,8 | 7,4<br>7,5 | > 300° |
| 5 | desgl. | Ph | OLi | I | 97 | ber.<br>gef. | 65,3<br>63,8 | 5,44<br>5,5 | 10,54<br>10,3 | 2,38<br>n. b. | > 340° |
| 6 | desgl. | Ph | OK | II<br>aus Verb. 10 | 90 | ber.<br>gef. | 58,9<br>58,0 | 4,91<br>5,0 | 9,51<br>9,3 | 11,96<br>11,2 | 305–308° |
| 7 | desgl. | Ph | OMg | II<br>aus Verb. 10 | 82 | ber.<br>gef. | 64,21<br>63,3 | 5,35<br>5,4 | 10,37<br>10,1 | 4,01<br>n. b. | n. b. |
| 8 | desgl. | Ph | OCa | II<br>aus Verb. 4 | 100 | ber.<br>gef. | 62,54<br>57,1 | 5,21<br>5,3 | 10,10<br>9,9 | 6,51<br>n. b. | 335° |
| 9 | desgl. | Ph | OBa | II<br>aus Verb. 4 | 86 | ber.<br>gef. | 54,01<br>52,4 | 4,50<br>4,7 | 8,72<br>5,7 | 19,27<br>n. b. | > 310° |
| 10 | desgl. | Ph | OH | II<br>aus Verb. 4 | 90 | ber.<br>gef. | 66,67<br>66,7 | 5,9<br>6,0 | 10,76<br>10,8 | | 146–149° |

Fortsetzung

| Nr. | Verbindung (Ph = Phenyl) $R^3$ | $R^1$ | $R^2$ | Herstell-verfahren | Aus-beute in % | Analyse | C | H | P | M | Schmp. |
|---|---|---|---|---|---|---|---|---|---|---|---|
| 11 | 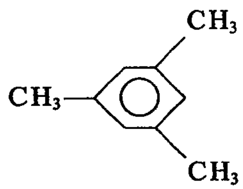 | Ph | $\overset{\ominus}{O}\overset{\oplus}{N}HEt_3$ | III | 100 | ber.<br>gef. | | | | | |
| 12 | desgl. | Ph | $\overset{\ominus}{O}H\overset{\oplus}{N}CH_3(CH_2CH_2OH)_2$ | III | 100 | ber.<br>gef. | 61,92<br>61,7 | 7,37<br>7,3 | 7,62<br>7,4 | | 84–89° |
| 13 | desgl. | Ph | $\overset{\ominus}{O}HPh\overset{\oplus}{N}(CH_2CH_3)_2$ | III | 100 | ber.<br>gef. | 71,42<br>70,2 | 7,32<br>7,2 | 7,09<br>7,3 | | < 20° |
| 14 | desgl. | Ph | $\overset{\ominus}{O}H\overset{\oplus}{N}(n\text{-}Bu)(CH_2CH_2OH)_2$ | III | 100 | ber.<br>gef. | 64,14<br>63,5 | 8,02<br>8,0 | 6,90<br>6,5 | | 78–83° |
| 15 | desgl. | Ph | $\overset{\ominus}{O}\overset{\oplus}{N}H_3Ph$ | III | 100 | ber.<br>gef. | 69,29<br>68,6 | 8,14<br>6,2 | 8,14<br>7,4 | | 167–168° |
| 16 | desgl. | Ph | $\overset{\ominus}{O}H\overset{\oplus}{N}Ph(CH_3)_2$ | III | 100 | ber.<br>gef. | 70,42<br>69,8 | 6,85<br>6,9 | 7,58<br>8,0 | | < 20° |
| 17 | desgl. | Ph | 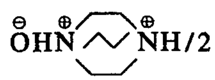 | III | 95 | ber.<br>gef. | 66,28<br>65,4 | 6,69<br>6,7 | 9,01<br>8,8 | | 154° |
| 18 | desgl. | Ph | $(CH_3CH_2)_2\overset{\oplus}{N}H-(CH_2)_2-O-CO-CH=CH_2$ | III | 95 | | | | | | 20° |
| 19 | desgl. | Ph | $N(CH_2-CH_3)_2$ | | | ber.<br>gef. | 69,97<br>69,8 | 7,58<br>7,6 | 9,04<br>9,0 | | 76–79° |
| 20 | desgl. | Ph | NH – Ph | | | ber.<br>gef. | 72,7<br>72,5 | 6,06<br>6,2 | 8,54<br>8,8 | | 157–159° |

Die erfindungsgemäßen Acylphosphinverbindungen eignen sich als Photoinitiatoren zur Photopolymerisation polymerisierbarer, olefinisch ungesättigte Verbindungen enthaltender Gemische, insbesondere solcher, die Wasser als Lösungsmittel bzw. Verdünnungsmittel enthalten.

Sie eignen sich beispielsweise zur Photopolymerisation von Druckplatten auf Basis von teil- oder vollverseiftem Polyvinylacetat oder Polyamiden, wobei eine für Reproduktionszwecke ausreichende bildmäßige Differenzierung erreicht wird. Sie eignen sich ferner zur Photopolymerisation wäßriger Emulsionen oder Lösungen olefinisch ungesättigter Monomerer bzw. aus solchen Emulsionen oder Lösungen gewonnener Monomermischungen. Dabei erhält man in vertretbarer Zeit und mit hohem Umsatz wäßrige Polymerdispersionen oder wäßrige Lösungspolymerisate, die in der Praxis brauchbar sind.

Durch Einwirkung von UV-Licht auf wäßrige Emulsionen von olefinisch ungesättigten Monomeren in Gegenwart von Emulgatoren und/oder Schutzkolloiden und der erfindungsgemäßen Verbindungen als Photoinitiatoren lassen sich stabile wäßrige Polymerisat-Dispersionen mit hohen Feststoffgehalten herstellen.

Ebenso lassen sich aus wäßrigen Lösungen wasserlöslicher, olefinisch ungesättigter Monomerer durch Bestrahlen mit UV-Licht in Gegenwart der erfindungsgemäßen Acylphosphinverbindungen Lösungspolymerisate mit hohem Molekulargewicht und geringem Restmonomerengehalt herstellen.

Mit den erfindungsgemäßen Photoinitiatoren werden Umsätze von 98 bis 100% ohne zusätzliche Peroxide oder Redoxinitiatoren erreicht. Die Lösungspolymerisate sind homogen und zeigen keine Verfärbung.

Als Lösungsmittel sind für die erfindungsgemäße Verwendung als Initiatoren für die Herstellung wäßriger Polymerisat-Lösungen oder -Emulsionen bzw. daraus gewonnener Mischungen alle gängigen Lösungsmittel wie Dimethylformamid, Aceton, Tetrahydrofuran, Kohlenwasserstoffe, Alkohole, Essigsäureester, vorzugsweise jedoch Wasser, geeignet.

Beim Einsatz zur Härtung von wäßrigen Polymerisat-Lösungen oder -Emulsionen bzw. daraus gewonnener Mischungen übertreffen die erfindungsgemäßen Photoinitiatoren den Stand der Technik (DE-OS 2 831 263) durch ihre Härtungsaktivität beträchtlich. Ferner ist vor der Photopolymerisation mit den in DE-OS 2 831 263 beschriebenen Verbindungen oftmals ein zeitaufwendiges Vorbestrahlen der Monomerenlösungen oder -emulsionen bzw. daraus gewonnener Mischungen erforderlich. Mit den aktiveren Verbindungen der vorliegenden Erfindung kann dieser Arbeitsgang entfallen.

Die erfindungsgemäßen Acylphosphinverbindungen eignen sich ebenfalls gut als Photoinitiatoren in photopolymerisierbaren Massen für Überzüge, Lacke, Druckfarben und Aufzeichnungsmaterialien. Sie sind hinsichtlich der Vergilbung der so erhaltenen Lacke bzw. Überzüge bekannten Photoinitiatoren, z.B. dem Benzildimethylketal, weit überlegen. Ferner lassen sich mit den erfindungsgemäßen Verbindungen höhere Härtungsgeschwindigkeiten von Lacken erzielen als mit dem letztgenannten Initiator oder den aus DE-OS 2 909 994 bekannten Acylphosphinoxiden. Schließlich ist die Lagerstabilität der mit den erfindungsgemäßen Verbindungen versetzten Harze besser als von Harzen, die als Photoinitiatoren Acylphosphinoxide nach DE-OS 2 909 994 enthalten. Deswegen eignen sich die erfindungsgemäßen Verbindungen sehr vorteilhaft für die Lichthärtung von styrolischen Polyesterharzen, die gegebenenfalls Glasfasern, Füllstoffe und andere Hilfsstoffe enthalten können.

Als olefinisch ungesättigte photopolymerisierbare Verbindungen kommen die üblichen Monomeren in Betracht, beispielsweise Mono- und Diolefine, wie Ethylen, Butadien, Isopren und Chloropren, olefinisch ungesättigte Carbonsäureester wie Acryl- und Methacrylsäureester von 1 bis 12 Kohlenstoffatome enthaltenden Alkoholen oder Vinylester von 2 bis 20 Kohlenstoffatome enthaltenden Fettsäuren, Vinyl- und Vinylidenhalogenide, wie besonders Vinylchlorid und Vinylidenchlorid, vinylaromatische Verbindungen, wie Styrol, $\alpha$-Methylstyrol und Vinyltoluole, Gemische derartiger Monomerer sowie Gemische solcher Monomerer mit $\alpha,\beta$-olefinisch ungesättigter Mono- und Dicarbonsäure, wie besonders Acrylsäure, Methacrylsäure, Maleinsäure, Fumarsäure und Itaconsäure, sowie deren Amide, N-Methylolamide, N-Alkoxymethylamide und Nitrile wie besonders Acrylamid, Methacrylamid, Maleinimid, Itaconsäurediamid, N-Methylolmethacrylamid, N-Methylolacrylamid, N-Methoxymethylacrylamid, N-n-Butoxymethylacrylamid, N-Methoxymethylmethacrylamid, Methylen-bis-acrylamid, Acrylnitril und Methacrylnitril.

Als Beispiele für ethylenisch ungesättigte Carbonsäureester, die für die Polymerisate von besonderem Interesse sind, seien Methylacrylat, Ethylacrylat und -methacrylat, Isopropylacrylat, n-Butylacrylat, Isobutylacrylat, tert.-Butylacrylat, 2-Ethylhexylacrylat und -methacrylat, 2-Hydroxyethylacrylat, 2-Hydroxyethylmethacrylat, Hydroxypropylacrylat, Hydroxypropylmethacrylat, Acrylate und Methacrylate zwei- und mehrwertiger Alkohole, z.B. Ethylenglykoldiacrylat, Butandiol-1,4-dimethacrylat, 1,1,1-Trimethylolpropantriacrylat. Acrylate und Methacrylate von Dialkoholen der Formel $HO(CH_2-CH_2O)_n$ mit $n = 2$ bis 20, ferner Vinylacetat, Vinylpropionat, Vinyllaurat, Vinylstearat und Vinylester verzweigter gesättigter Carbonsäuren, z.B. von Pivalinsäure, genannt.

Von besonderem Interesse sind solche wäßrigen Polymerisat-Dispersionen, die Polymerisate bzw. Mischpolymerisate enthalten, die sich von Acryl- und/oder Methacrylsäureestern 1 bis 8 Kohlenstoffatome enthaltender Alkanole und/oder von Vinylestern 2 bis 12 Kohlenstoffatome enthaltender gesättigter Monocarbonsäuren oder von Gemischen aus Butadien mit Styrol und/oder Acrylnitril ableiten und die vorzugsweise 0,5 bis 5 Gew.-%, bezogen auf die Polymerisate, 3 bis 5 C-Atome aufweisende $\alpha,\beta$-olefinisch ungesättigte Carbonsäuren der oben genannten Art einpolymerisiert enthalten.

Von besonderem Interesse sind auch wäßrige Polymerlösungen, die Polymerisate bzw. Mischpolymeri sate von Acrylsäure, Methacrylsäure, Acrylamid, Methacrylamid, N-Alkanolamiden der Acryl- und/ oder Methacrylsäure und/oder wasserlösliche Hydroxyalkylacrylate enthalten.

Als Emulgatoren zur erfindungsgemäßen Herstellung wäßriger Polymerisatdispersionen werden im allgemeinen ionische und/oder nichtionische Emulgatoren, wie Polyglykolether, sulfonierte Paraffinkohlenwasserstoffe, höhere Alkylsulfate wie Laurylsulfat, Alkalisalze von Fettsäuren wie Natriumstearat und Natriumoleat, Schwefelsäureester von Fettalkoholen, oxethylierte $C_8$- bis $C_{12}$-Alkylphenole mit meist 5 bis 30 Ethylenoxidresten sowie deren Sulfonierungsprodukte sowie ferner Sulfobernsteinsäureester in Mengen, die meist zwischen 0,1 und 10,0 Gew.-%, bezogen auf die Monomeren, liegen, eingesetzt. Zusätzlich wird in manchen Fällen auch ein Schutzkolloid mitverwendet. Als Schutzkolloide kommen z.B. Polyvinylalkohol, teilverseifte Polyvinylacetate, Cellulosederivate, Copolymerisate von Acrylsäuremethylester mit Acryl- und Methacrylsäureamid oder Vinylpyrrolidonpolymerisate in Mengen zwischen etwa 0,5 und 10, insbesondere zwischen 1,0 und 5 Gew.-%, bezogen auf die Monomeren, in Frage.

Die erfindungsgemäßen Photoinitiatoren werden in Konzentrationen von 0,001 bis 10 Gew.-%, vorzugsweise 0,01 bis 1 Gew.-%, bezogen auf die olefinisch ungesättigten Verbindungen eingesetzt. In diesem Konzentrationsbereich lösen sich die Photoinitiatoren vollständig in Wasser auf. Sie können gegebenenfalls mit Beschleunigern kombiniert werden, die den hemmenden Einfluß des Luftsauerstoffs auf die Photopolymerisation beseitigen.

Die Durchführung der Photopolymerisation wäßriger Lösungen oder Emulsionen unter Verwendung der erfindungsgemäßen Photoinitiatoren kann sowohl diskontinuierlich als auch kontinuierlich geschehen. Die einzelnen Komponenten werden nach bekannten Verfahren emulgiert bzw. gelöst. Diese Emulsionen bzw. Lösungen werden dann mit Licht bestrahlt. Die Abführung der Polymerisationswärme kann durch äußere Kühlung, aber auch durch Verdampfungskühlung erfolgen. Die Bestrahlungsdauer hängt von der Art der Durchführung, von der Art und Konzentration der eingesetzten Monomeren, von der Art und Menge der eingesetzten Photoinitiatoren, von der Intensität der Lichtquelle und von der Größe des Ansatzes ab und kann 5 Minuten bis 4 Stunden, vorzugsweise 10 Minuten bis 3 Stunden betragen. Die Polymerisationstemperatur ist dabei frei wählbar und kann +5 bis ca. 100°C betragen. Polymerisationstemperaturen von 10 bis 40°C sind besonders bevorzugt. Die Feststoffgehalte der erfindungsgemäß hergestellten Dispersionen liegen zwischen 5 und 60 Gew.-%, im allgemeinen zwischen 30 und 50 Gew.-%. Der Gehalt an Restmonomeren ist niedrig. Die K-Werte (nach Fikentscher) der erhaltenen Dispersionen sind hoch, im allgemeinen $> 90$.

Zusätzlich zu den vorgenannten Verbindungen eignen sich für die Herstellung von photopolymerisierbaren Massen, für die Herstellung von Lacken und Überzügen, UP-Harzformmassen, Druckfarben und Aufzeichnungsmaterialien höhermolekulare Verbindungen, z.B. ungesättigte Polyester, hergestellt durch Umsetzung von $\alpha,\beta$-ungesättigten Dicarbonsäuren, wie Maleinsäure, Fumarsäure oder Itaconsäure, gegebenenfalls im Gemisch mit gesättigten bzw. aromatischen Dicarbonsäuren wie Adipinsäure, Phthalsäure oder Terephthalsäure, mit Alkandiolen wie Ethylenglykol, Propylenglykol, Butandiol, Neopentylglykol oder oxalkyliertem Bisphenol A; Epoxidacrylate, hergestellt aus Acryl- oder Methacrylsäure und aromatischen oder aliphatischen Diglycidethern; Urethanacrylate, hergestellt aus Hydroxyalkyl acrylaten und Polyisocyanaten sowie Polyesteracrylate, hergestellt aus hydroxylgruppenhaltigen gesättigten Polyestern und Acryl- oder Methacrylsäure.

Den photopolymerisierbaren Verbindungen, deren Zusammensetzung für den jeweiligen Verwendungszweck dem Fachmann geläufig ist, können in bekannter Weise gesättigte und/oder ungesättigte Polymere sowie weitere Zusatzstoffe, wie Inhibitoren gegen die thermische Polymerisation, Paraffin, Pigmente, Farbstoffe, Peroxide, Verlaufshilfsmittel, Füllstoffe und Glasfasern sowie Stabilisatoren gegen thermischen oder photochemischen Abbau zugesetzt sein.

Als Beschleuniger bzw. Synergisten eignen sich beispielsweise sekundäre und tert. Amine, wie Methyldiethanolamin, Dimethylethanolamin, Triethylamin, Triethanolamin, p-Dimethylaminobenzoesäureethylester, Benzyl-dimethylamin, Dimethylaminoethylacrylat, N-Phenylglycin, N-Methyl-N-phenylglycin. Zur Beschleunigung der Aushärtung können weiterhin aliphatische und aromatische Halogenide dienen, die 2-Chlormethylnaphthalin, 1-Chlor-2-chlormethyl-naphthalin sowie gegebenenfalls Radikalbildner, wie sie im allgemeinen als Initiatoren für die thermische Polymerisation eingesetzt werden, z.B. Peroxide, Azo-Verbindungen sowie C-C-labile Verbindungen, die in Mengen von bis zu 15 Gew.-%, bezogen auf die photopolymerisierbare Masse, zugesetzt werden können.

Ferner können die Acylphosphinverbindungen, gegebenenfalls in Anwesenheit der oben bezeichneten Synergisten und Beschleuniger, in Kombination mit anderen Photoinitiatoren zur Lichthärtung von Überzügen, Lacken, Druckfarben, photosensiblen Aufzeichnungsmaterialien, wie z.B. photopolymerisierbaren Druckplatten und styrolischen Polyesterharzen eingesetzt werden. Solche Photoinitiatoren sind z.B. aromatische Ketone wie Benzilketale, Benzoinether, Benzoinester, $C_1$- bis $C_3$-alkyl, chlor- oder chlormethyl-substituierte Thioxanthone, die in der deutschen Patentanmeldung DE-OS 3 020 092 beschriebenen Acylphosphine sowie die aus DE-OS 2 830 927 und DE-OS 2 909 994 bekannten Acylphosphinoxide und Acylphosphinsäureester. Ferner zählen dazu aromatische Disulfide und Naphthalinsulfochloride.

Als Strahlungsquellen für das die Polymerisation solcher Mischungen auslösende Licht verwendet

man im allgemeinen solche, die Licht vorzugsweise im Absorptionsbereich der erfindungsgemäßen Verbindungen aussenden, d. h. zwischen 230 und 450 nm. Besonders geeignet sind Quecksilber-Niederdruckstrahler, -Mitteldruck- und Hochdruckstrahler, sowie superaktinische Leuchtstoffröhren oder Impulsstrahler. Die genannten Lampen können gegebenenfalls dotiert sein.

Die in den nachstehenden Beispielen genannten Teile und Prozente beziehen sich, soweit nicht anders angegeben, auf das Gewicht. Volumenteile verhalten sich zu Teilen wie Liter zu Kilogramm.

Beispiel 1

Natrium-2,4,6-trimethylbenzoylphenylphosphinat (Verbindung 4)

60,5 Gew.-Teile 2,4,6-Trimethylbenzoylphenylphosphinsäuremethylester (nach EP-OS 7 086) und 33 Gew.-Teile Natriumjodid wurden in 560 Volumenteilen Methylethylketon gelöst und 2,5 Stunden bei 55°C gerührt. Der dabei ausgefallene Niederschlag wurde abfiltriert und mit Methylethylketon nachgewaschen. Nach dem Trocknen verblieb das Produkt.

Beispiel 2

2,4,6-Trimethylbenzoylphenylphosphinsäure (Verbindung 10)

46,5 Gew.-Teile Natriumsalz nach Beispiel 1 wurden in 300 Gew.-Teilen Wasser gelöst und 150 Volumenteile 1 — normaler Schwefelsäure zugegeben. Der ausgefallene Niederschlag wurde abgesaugt und mit Wasser gewaschen. Nach dem Trocknen verblieben 38,9 Gew.-Teile des Produkts.

Beispiel 3

Calcium-bis(2,4,6-trimethylbenzoylphenylphosphinat (Verbindung 8)

15 Gew.-Teile Natriumsalz nach Beispiel 1 wurden in 75 Gew.-Teilen Wasser gelöst und zu dieser Lösung portionsweise 125 Volumenteile einer 10%igen wäßrigen Calciumchloridlösung zugegeben. Der dabei ausfallende Niederschlag wurde abgesaugt und mit Wasser gewaschen. Nach dem Trocknen im Vakuumtrockenschrank bei 50°C wurden 14,7 Gew.-Teile des Produkts erhalten.

Beispiel 4

Methyldiethanolammonium-2,4,6-trimethylbenzoylphenylphosphinat (Verbindung 12)

5,8 Gew.-Teile 2,4,6-Trimethylbenzoylphenylphosphinsäure wurden in 30 Volumenteilen Methylenchlorid gelöst und 2,4 Gew.-Teile Methyldiethanolamin zugegeben. Nach Abziehen von Methylenchlorid verblieb das Reaktionsprodukt.

Beispiel 5

Zur Messung der Härtungsaktivität wurde der Temperaturverlauf im ungesättigten Polyesterharz (UP-Harz) während der UV-Belichtung aufgezeichnet; dazu tauchte ein mit einer Wachsschicht überzogener Thermofühler, der mit einem Temperaturschreiber (®Tastotherm Script 3N, Standardfühler T300 der Deutschen Gulton GmbH) verbunden war, in einen mit 10 g UP-Harz gefüllten Weißblechdeckel mit einem Durchmesser von 5 cm (Schichtdicke des UP-Harzes 4,8 mm). Zur Vermeidung von Wärmeverlusten während der UV-Belichtung war der Deckel in Polyurethan-Hartschaum eingebettet. Als Strahlungsquelle diente ein UV-Feld aus 5 Leuchtstoffröhren (TLAK40 W/05, Philips) nebeneinander. Der Abstand Strahler/UP-Harzoberfläche betrug 8,5 cm.

Aus den registrierten Temperatur-Zeitkurven wurden als charakteristische Kenngrößen für die Härtungsaktivität die Härtungszeit $HZ_{25°C\text{-}T_{max}}$ und die maximal erreichte Härtungstemperatur $T_{max}$ entnommen. Als Härtungszeit gilt die Zeitspanne, in der die Probentemperatur von 25°C auf $T_{max}$ ansteigt.

Die Beispiele und Vergleichsbeispiele wurden mit folgenden ungesättigten Polyesterharzen durchgeführt:

Harz A ist eine mit 0,01 % Hydrochinon stabilisierte, 65 %ige styrolische Lösung eines ungesättigten Polyesters aus Maleinsäure, o-Phthalsäure, Ethylenglykol und Propylenglykol-1,2 im Molverhältnis 1:2:2,3:0,70. Der ungesättigte Polyester hat eine Säurezahl von 50.

Harz B ist eine mit 0,01 % Hydrochinon stabilisierte, 67 %ige styrolische Lösung eines ungesättigten Polyesters aus Maleinsäure, Tetrahydrophthalsäure und Diethylenglykol im Molverhältnis 1:0,5:1,5. Der ungesättigte Polyester hat eine Säurezahl von 43.

Harz C ist eine mit 0,01 % Hydrochinon stabilisierte, 66 %ige styrolische Lösung eines ungesättigten Polyesters aus Maleinsäure, o-Phthalsäure und Propylenglykol-1,2 im Molverhältnis 1:0,5:1,5. Der ungesättigte Polyester hat eine Säurezahl von 50.

Die Härtungsaktivität der erfindungsgemäßen Verbindungen 1 bis 16 (vgl. Tabelle 1) wurde mit den Eigenschaften der folgenden Verbindungen verglichen:

I 2,4,6-Trimethylbenzoylphenylphosphinsäuremethylester nach DE-OS 2 909 994
II 2,4,6-Trimethylbenzoylphenylphosphinsäureisopropylester nach DE-OS 2 909 994
III Benzildimethylketal nach DE-PS 2 261 383
IV Mononatrium-monomethyl-acetylphosphonat nach EP-OS 9 348

Die Ergebnisse sind in Tabelle 2 zusammengefaßt.

Tabelle 2 zeigt, daß die erfindungsgemäßen Verbindungen 4 bis 18 den Vergleichsverbindungen I bis III, die den Stand der Technik repräsentieren, in ihrer Härtungsaktivität deutlich überlegen sind. Tabelle 2 zeigt ferner, daß die in EP-OS 9 348 beschriebene Vergleichsverbindung IV sich nicht zur Photohärtung eignet.

Tabelle 2
Härtungsaktivität verschiedener Verbindungen

| Verbindung (0,2 %) | Härtungsaktivität UP-Harze A | | B | | C | |
|---|---|---|---|---|---|---|
| | $HZ_{25°-T_{max}}$ (min/s) | $T_{max}$ (°C) | $HZ_{25°-T_{max}}$ (min/s) | $T_{max}$ (°C) | $HZ_{25°-T_{max}}$ (min/s) | $T_{max}$ (°C) |
| I | 7/45 | 114 | 5/23 | 127 | 6/53 | 123 |
| II | 6/45 | 107 | 5/15 | 128 | 6/08 | 120 |
| III | 8/00 | 114 | 9/45 | 119 | 8/30 | 122 |
| IV | 13/15 | 30[1]) | – | – | – | – |
| 4 | 5/53 | 117 | 4/37 | 125 | 5/23 | 122 |
| 5 | 5/38 | 118 | – | – | – | – |
| 6 | 5/53 | 115 | – | – | – | – |
| 8 | 5/53 | 114 | 6/00 | 130 | – | – |
| 9 | 5/53 | 110 | 4/45 | 125 | 5/45 | 129 |
| 11 | 5/23 | 118 | 4/30 | 124 | 5/15 | 120 |
| 12 | 6/15 | 116 | 5/08 | 129 | 5/23 | 123 |
| 13 | 6/08 | 115 | 5/30 | 126 | 5/23 | 121 |
| 14 | 5/30 | 122 | 4/53 | 118 | 5/38 | 123 |
| 15 | 7/15 | 113 | 8/00 | 119 | 7/30 | 109 |
| 16 | 5/15 | 115 | – | – | – | – |
| 17 | 5/38 | 120 | – | – | – | – |

[1]) nicht gehärtet

Beispiel 6

Zur Prüfung der Lagerstabilität wurden je 6,6 ml der UP-Harze A, B, C (vgl. Beispiel 5) mit einem Initiatorgehalt von 0,2 % in braune Probefläschchen gefüllt und verschlossen bei 60°C gelagert. In Abständen von ca. 12 Stunden wurde durch Umdrehen der Fläschchen geprüft, ob sich Gelteilchen gebildet hatten. Als Maß für die Lagerstabilität ist in Tabelle 3 die Lagerzeit angegeben, bei der noch keine Gelteilchen beobachtet wurden.

Zusätzlich zu den Vergleichsverbindungen I, II, III wurde folgende Verbindung V geprüft:

V 2,4,6-Trimethylbenzoyldiphenylphosphinoxid nach DE-OS 2 909 994

Die Numerierung der Verbindungen in Tabelle 3 bezieht sich auf Tabelle 1.

Tabelle 3
Lagerstabilität von UP-Harzen mit Photoinitiator

| Verbindung | Lagerstabilität (h) der UP-Harze | | |
|---|---|---|---|
| | A | B | C |
| I | 180 | 155 | 180 |
| II | 140 | 155 | 120 |
| V | 140 | 140 | 120 |
| 4 | 190 | – | – |
| 9 | 180 | 140 | 180 |
| 11 | 180 | 155 | 204 |
| 14 | 180 | 155 | 204 |
| 17 | 270 | – | – |
| 18 | 270 | – | – |

Nach Tabelle 3 sind die erfindungsgemäßen Verbindungen 4, 9, 11, 14, 17 und 18 bezüglich der Lagerstabilität der damit versetzten Harze den Verbindungen II, III, V deutlich überlegen. Im Vergleich zu I ist zwar die Lagerstabilität von 4, 9, 11 und 14 nicht signifikant verschieden, jedoch besitzt I eine deutlich geringere Härtungsaktivität als die patentgemäßen Verbindungen (s. Beispiel 5).

Beispiel 7

Durch Veresterung von 143 Teilen Tetrahydrophthalsäureanhydrid und 175 Teilen Maleinsäureanhydrid mit 260 Teilen Diethylenglykol wird ein ungesättigter Polyester hergestellt. Nach Zugabe von 0,01 % Hydrochinon wird von dem Polyester eine 64 %ige Lösung in Styrol hergestellt (Lösung D).

Für die UV-Härtungsversuche werden zu 100 Teilen der Lösung D 10 Teile Styrol und 2 Teile Photoinitiator gegeben und der Lack mit einem Filmziehgerät (Spaltbreite 200 μm) auf eine mit Photopapier beschichtete Hartfaserplatte aufgetragen.

Nach etwa 1minütigem Ablüften werden die Filme mit Quecksilberhochdrucklampen bestrahlt (30 Watt/1 cm Bogenlänge, Philips HTQ 7), die im Abstand von 15 cm über dem Objektiv angeordnet sind.

Die Härtungsgeschwindigkeit wird durch Messung der Pendeldämpfung nach König (DIN 53 157) bestimmt und ist in Tabelle 4 gemeinsam mit den Farbmessungen der ausgehärteten Filme zusammengestellt.

Die Bezeichnung der Photoinitiatoren bezieht sich auf Tabelle 1 bzw. Beispiel 6.

Tabelle 4

| Photoinitiator | Pendeldämpfung nach Bestrahlungszeit von | | | | |
|---|---|---|---|---|---|
| | 5s | 10s | 15s | 20s | 25s |
| V | 43 | 66 | 84 | 102 | 112 |
| 12 | 71 | 92 | 112 | 122 | 130 |

Wie Tabelle 4 zeigt, übertrifft Verbindung 12 die Vergleichsverbindung V in ihrer Härtungsaktivität deutlich.

## Beispiel 8

Aus 50 Teilen Methylacrylat, 50 Teilen Ethylacrylat, 1,3 Teilen $C_{15}$-Paraffinsulfonat (40 %ig), 1,3 Teilen Additionsprodukt von Isooctylphenol mit 25 Einheiten Ethylenoxid (20 %ig) und 210 Teilen Wasser wird in einem üblichen Mischaggregat eine Monomeren-Emulsion hergestellt.

Diese Emulsion wird in einem mit Innenthermometer und Rührer versehenen 1 l-Glaskolben durch zweimaliges Evakuieren und Begasen mit Stickstoff von Sauerstoff befreit. Nach Zugabe von X Teilen Photoinitiatoren in 6,7 Teilen Wasser wird das Reaktionsgefäß mit einer Quecksilberdampf-Hochdrucklampe des Typs HQL/R 400 W von Osram im Abstand von 30 cm 60 min lang von oben bestrahlt. Das Anspringen der Polymerisation macht sich durch einen Temperaturanstieg bemerkbar. In Tabelle 5 sind die eingesetzten Mengen Photoinitiator und die Eigenschaften der erhaltenen Polymerisat-Dispersionen zusammengestellt. Der Photoinitiator 4 (vgl. Tabelle 1) wird dabei mit dem Initiator VI (nach DE-OS 2 831 263) verglichen. Bei gleicher Einsatzkonzentration wird mit Initiator 4 ein deutlich niedrigerer Gehalt an Restmonomeren erhalten als mit Initiator VI.

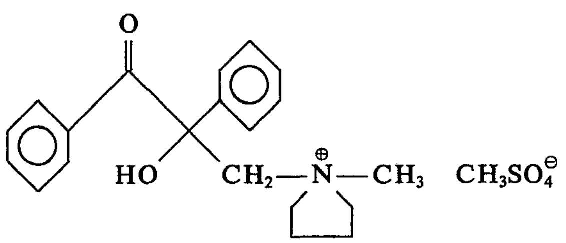

(VI)

Initiator 4 erlaubt die Photopolymerisation auch bei sehr niedrigen Einsatzkonzentrationen, bei denen Initiator VI die Polymerisation nicht mehr auslöst. Beide Ergebnisse zeigen deutlich die höhere Aktivität von Initiator 4 gegenüber VI bei gleichen K-Wert der erhaltenen Polymerisat-Dispersionen.

Tabelle 5

| Photoinitiator | eingesetzte Teile X | Feststoff-gehalt | Restmonomere Ethylacrylat | Restmonomere Methylacrylat | K-Wert nach Fikentscher |
|---|---|---|---|---|---|
| 4 | 1,7 | 31,4 | <0,005 % | 0,005 % | 146,6 |
| VI | 1,7 | 30,8 | 0,012 % | 0,036 % | 146,1 |
| 4 | 0,04 | 31,3 | 0,019 % | 0,051 % | 156,8 |
| VI | 0,04 | ← | keine Polymerisation | → | |

## Beispiel 9a bis c

294 Teile eines teilverseiften Polyvinylacetats (Verseifungsgrad 82 Mol-%, mittlerer Polymerisationsgrad 500) werden durch mehrstündiges Rühren in 294 Teilen vollentsalztem Wasser bei 90°C gelöst. Nach Abkühlen auf 70°C werden unter Rühren 20 Teile 1,1,1-Trimethylolpropantriacrylat, 1,0 Teile 2,6-Di-tert.-butyl-p-kresol und die in Tabelle 6 angegebene Menge an Photoinitiator, gelöst in 230 Teilen

2-Hydroxyethylmethacrylat, zugegeben. Die homogene viskose Lösung wird filtriert und unter reduziertem Druck entgast und entwässert. Durch Aufbringen auf ein mit einem Haftlack versehenes Stahlblech und 24-stündiges Trocknen bei Raumtemperatur wird eine 550 μm starke, nicht klebende Schicht erhalten. Die Druckplatte wird nach 2 Sekunden Vorbelichtung bildmäßig durch ein Negativ mittels eines handelsüblichen Belichters (5 kW) belichtet, wobei die in Tabelle 6 angegebenen Zeiten angewandt werden. Auswaschen mit Wasser in einem Sprühwäscher und Trocknen bei 100°C ergeben ein Klischee mit sehr guten Druckeigenschaften.

Die thermische Stabilität der lichtempfindlichen Ansatzlösungen wird durch Aufbewahren einer Probe in einer verschlossenen Ampulle bei 80°C ermittelt. Die erfindungsgemäßen Photoinitiatoren verbessern im Vergleich zu Verbindung V — bei sonst recht ähnlichem Verhalten — die Stabilität der lichtempfindlichen Mischung um den Faktor 2 (s. Tabelle 6).

Tabelle 6

| Bsp. | Photoinitiator | Hauptbelichtungszeit | Stabilität |
|---|---|---|---|
| a | 4 Teile Verb. V | 30 Sek. | 15 Stunden |
| b | 6 Teile Verb. 4 | 30 Sek. | 34 Stunden |
| c | 7 Teile Verb. 12 | 35 Sek. | 28 Stunden |

Beispiel 10

60 Gewichtsteile eines 1:1:1-Copolyamides aus PA-6, PA-6.6, PA-6.13, 30 Gewichtsteile Bis(N-methylolacrylamid)ethylenglykolether, 10 Gewichtsteile N(n-butyl)benzolsulfonsäureamid, 150 Gewichtsteile Methanol, 20 Gewichtsteile Wasser, 0,02 Gewichtsteile eines Chromkomplexfarbstoffes (CI-Nr. 12195), 0,3 Gewichtsteile N-Nitrosocyclohexylhydroxylamin-Kaliumsalz sowie 2 Gewichtsteile der in Tabelle 7 angegebenen Photoinitiatoren werden bei ca. 70°C gelöst. Durch Abdestillation eines Teils des Lösungsmittels wird die photopolymerisierbare Masse auf einen Feststoffgehalt von ca. 65% gebracht und bei 60°C auf ein mit einem Haftlack versehenes Stahlblechband so aufgegossen, daß nach etwa 2stündiger Trocknung bei 80°C in einem Trockenschrank photopolymerisierbare Druckplatten mit einer Schichtdicke von 0,5 mm und einem Feststoffgehalt der Schicht von ca. 95% entstehen.

Unter Verwendung eines Testnegativs, das u.a. 3%ige. Rastertonwerte der Rasterlinienweite 54 Linien pro Zentimeter enthält, werden die Platten auf einem Flachbelichter, der mit superaktinischen Leuchtstoffröhren bestückt ist, bei einer UV-Lichtintensität von ca. 3300 $\mu W/cm^2$ belichtet. Anschließend werden die durch die opaken Bildelemente des Negativs vor dem UV-Licht geschützten unbelichteten Anteile der Platte mit einem Ethanol-Wasser-Gemisch (80% Ethanol) in einem Sprühwäscher bei 30°C und 5 bar Sprühdruck innerhalb von 5 Minuten ausgewaschen. Die Klischees werden danach 6 Minuten bei 110°C getrocknet. Gemessen wird die zur fehlerfreien Reproduktion des 3%igen Rastertonwertes erforderliche Mindestbelichtungszeit. Diese ist für verschiedene Photoinitiatoren in Tabelle 7 zusammengestellt.

Tabelle 7

| Initiator | Mindestbelichtungszeit zur Reproduktion des 3%igen Rastertonwertes |
|---|---|
| 14 | 110 s |
| 4 | 115 s |
| III | 165 s |
| V | 190 s |

**Patentansprüche:**

1. Acylphosphin-Verbindungen der allgemeinen Formel

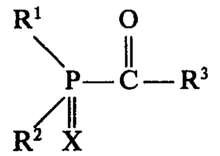

(I)

wobei die Substituenten folgende Bedeutung haben:

$R^1$ ist gleich $R^4$ oder $OR^4$,

$R^2$ steht für die Gruppierungen $-O^-M^+$ oder $-NR^5R^6$, wobei ein $M^+$ ein Äquivalent eines Kations der 1. bis 3. Hauptgruppe des Periodensystems mit einem Atomgewicht unter 138 oder der Ammoniumionen

$^{\oplus}NR^5R^6R^7R^8$ (II)

oder

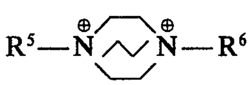

(II')

bedeutet, wobei $R^5$ bis $R^8$ gleich oder verschieden sind und für Wasserstoff, einen geradkettigen oder verzweigten Alkylrest mit bis zu 18 C-Atomen, die gegebenenfalls durch eine Hydroxylgruppe substituiert sein können, für den Cyclohexyl-, Cyclopentyl-, Allyl- oder Phenylrest oder die $\beta$-(Meth)Acryloxyethylgruppe stehen, oder in der Formel II zwei dieser Substituenten zusammen mit dem Stickstoff einen 5- bis 7gliedrigen Ring bilden, der gegebenenfalls ein Sauerstoff- oder ein weiteres Stickstoffatom enthalten kann,

$R^3$ ist ein substituierter Phenyl-, Naphthyl-, Pyridyl-, Pyrrolyl-, Furyl- oder Thienylrest, der zumindest an den beiden zur Verknüpfungsstelle mit der Carbonylgruppe benachbarten Kohlenstoffatomen Substituenten trägt, die gleich oder verschieden sein können, und die bis zu 6 Kohlenstoffatome enthaltende, geradkettige oder verzweigte Alkyl-, Alkoxy- oder Alkylthio-Reste, bis zu 7 Kohlenstoffatome enthaltende Cycloalkyl- oder Phenylreste, Nitril-, Carboxyl-, Carboalkoxygruppen oder die Halogenatome, Fluor, Chlor oder Brom sein können,

$R^4$ steht für Wasserstoff, einen geradkettigen oder verzweigten Alkyl- oder Alkenyl-Rest mit bis zu 8 Kohlenstoffatomen, welcher gegebenenfalls durch die Gruppierung $-NR^5R^6$ substituiert sein kann, den Cyclohexyl- oder Cyclopentyl-Rest oder einen gegebenenfalls bis zu dreifach substituierten Phenylrest, wobei die Substituenten geradkettige oder verzweigte, bis zu 6 Kohlenstoffatome enthaltende Alkyl-, Alkoxy-, Alkylthio- oder $NR^5R^6$-Gruppen oder die Halogenatome Fluor, Chlor oder Brom sein können;

X steht für Sauerstoff oder Schwefel oder bedeutet ein freies Elektronenpaar am Phosphor.

2. Acylphosphinverbindungen nach Anspruch 1, dadurch gekennzeichnet, daß X für Sauerstoff steht.

3. Acylphosphinverbindungen nach Anspruch 1, dadurch gekennzeichnet, daß $R^3$ ein 2,6-Dimethylphenyl-, 2,4,6-Trimethylphenyl-, 2,3,6-Trimethylphenyl-, 2,6-Dimethoxyphenyl-, 2,6-Dichlorphenyl-, 2,6-Bis(methylthio)-phenyl-, ein 2,3,5,6-Tetramethylphenyl-, ein 2,6-Dimethyl-4-tert.-Butylphenyl-, ein 2,4,6-Trimethylpyridyl-3-, ein 2,4-Dimethylthienyl-3-, ein 1,3-Dimethylnaphthalin-2- oder ein 1,3-Dimethoxynaphthalin-2-Rest ist.

4. Acylphosphinverbindungen nach Anspruch 3, dadurch gekennzeichnet, daß $R^1$ für eine gegebenenfalls ein- bis dreifach substituierte Phenylgruppe steht.

5. Verwendung der Acylphosphinverbindungen nach Anspruch 1 bis 4 als Photoinitiatoren in photopolymerisierbaren Massen.

6. Verwendung der Acylphosphinverbindungen nach Anspruch 5 in Kombination mit sekundären oder tertiären Aminen.

7. Verwendung der Acylphosphinverbindungen nach Anspruch 1 bis 4 als Photoinitiatoren in photopolymerisierbaren Überzugsmitteln, Lacken, Druckfarben und Aufzeichnungsmaterialien, wobei diese den Photoinitiator in einer Konzentration von 0,01 bis 10% enthalten.

8. Verwendung nach Anspruch 5 oder 6 zur Herstellung von Kunststoffmassen auf Basis ungesättigter Polyesterharze, die gegegebenenfalls weitere Hilfsstoffe, insbesondere Glasfasern und/oder Füllstoffe enthalten.

9. Verwendung nach Anspruch 5 bis 8, dadurch gekennzeichnet, daß als Photoinitiatoren Acylphosphinverbindungen der allgemeinen Formel (I) in Kombination mit Verbindungen aus der Gruppe der Benzilketale, Benzoinether, Benzoinester, $C_1$- bis $C_4$-alkyl-, chlor- oder chlormethyl-substituierten Thioxanthone, aromatischen Disulfide, Naphthalinsulfochloride, Acylphosphine, Acylphosphinoxide, Acylphosphinsäureester und Acylphosphinsulfide eingesetzt werden.

10. Verwendung der Acylphosphinverbindungen nach Anspruch 5 bis 8, dadurch gekennzeichnet, daß die Acylphosphinverbindungen in Kombination mit Initiatoren für die thermische Polymerisation eingesetzt werden.

11. Verwendung der Verbindungen nach Anspruch 1 bis 4 als Initiatoren zur Photopolymerisation photopolymerisierbarer Gemische, die Wasser enthalten.

12. Verwendung nach Anspruch 11 zur Herstellung wäßriger Polymerisat-Dispersionen oder Polymeri sat-Lösungen.

**Claims**

1. An acylphosphine compound of the general formula

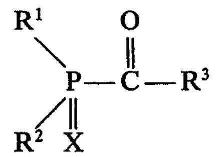

(I)

where

$R^1$ is $R^4$ or $OR^4$,

$R^2$ is $-O^-M^+$ or $-NR^5R^6$, where $M^+$ is one equivalent of a cation, with an atomic weight of less than 138, of the main groups 1 to 3 of the Periodic Table, or the ammonium ion

$$^{\oplus}NR^5R^6R^7R^8 \quad (II)$$

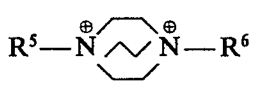

(II')

where $R^5$, $R^6$, $R^7$ and $R^8$ are identical or different and each is hydrogen or straight-chain or branched alkyl of up to 18 carbon atoms which is unsubstituted or substituted by a hydroxyl group, or is cyclohexyl, cyclopentyl, allyl, phenyl or $\beta$-(meth)acryloxyethyl, or, in the formula II, two of these substituents together with the nitrogen atom form a 5-membered to 7-membered ring which may or may not contain an oxygen atom or a further nitrogen atom,

$R^3$ is a substituted phenyl, naphthyl, pyridyl, pyrrolyl, furyl or thienyl radical which bears substituents at least on the two carbon atoms adjacent to the point of attachment to the carbonyl group, which substituents may be identical or different and may be straight-chain or branched alkyl, alkoxy or alkylthio of up to 6 carbon atoms, cycloalkyl or phenyl of up to 7 carbon atoms, or nitrile, carboxyl or carboalkoxy, or a halogen atom, namely fluorine, chlorine or bromine,

$R^4$ is hydrogen or straight-chain or branched alkyl or alkenyl of up to 8 carbon atoms, which is unsubstituted or substituted by the group $-NR^5R^6$, or is cyclohexyl or cyclopentyl, or phenyl is monosubstituted to trisubstituted by straight-chain or branched alkyl, alkoxy, alkylthio or $NR^5R^6$ groups of up to 6 carbon atoms, or by a halogen atom, namely fluorine, chlorine or bromine, and

X is oxygen or sulfur, or a free electron pair on phosphorus.

2. An acylphosphine compound as claimed in claim 1, wherein X is oxygen.

3. An acylphosphine compound as claimed in claim 1, wherein $R^3$ is 2,6-dimethylphenyl, 2,4,6-trimethylphenyl, 2,3,6-trimethylphenyl, 2,6-dimethoxyphenyl, 2,6-dichlorophenyl, 2,6-bis-(methylthio)-phenyl, 2,3,5,6-tetramethylphenyl, 2,6-dimethyl-4-tert.-butylphenyl, 2,4,6-trimethylpyrid-3-yl, 2,4-dimethylthien-3-yl, 1,3-dimethylnaphth-2-yl or 1,3-dimethoxynaphth-2-yl.

4. An acylphosphine compound as claimed in claim 3, wherein $R^1$ is phenyl which is unsubstituted or monosubstituted to trisubstituted.

5. The use of an acylphosphine compound as claimed in claims 1 to 4 as a photoinitiator in photopolymerizable compositions.

6. The use of an acylphosphine compound, as claimed in claim 5, in combination with secondary or tertiary amines.

7. The use of an acylphosphine compound as claimed in claims 1 to 4 as a photoinitiator in photopolymerizable coating materials, surface coatings, printing inks and recording materials, the photoinitiator being contained therein in an amount of from 0.01 to 10%.

8. The use as claimed in claim 5 or 6 for the production of plastics compositions based on unsaturated polyester resins which may, if desired, contain other additives, especially glass fibers and/or fillers.

9. The use as claimed in claims 5 to 8, wherein there is used as photoinitiator an acylphosphine compound of the general formula (I) in combination with a compound selected from the group consisting of a benzoin ketal, a benzoin ether, a benzoin ester, a $C_1-C_4$-alkyl-substituted, chlorine-substituted or chloromethyl-substituted thioxanthone, an aromatic disulfide, a naphthalenesulfochloride, an acylphosphine, an acylphosphine oxide, an acylphosphine acid ester and an acylphosphine sulfide.

10. The use of an acylphosphine compound, as claimed in claims 5 to 8, wherein the acylphosphine compound is used in combination with a thermal polymerization initiator.

11. The use of a compound as claimed in claims 1 to 4 as an initiator for photopolymerizing photopolymerizable mixtures containing water.

12. The use as claimed in claim 11 for the production of aqueous polymer dispersions or solutions.

**Revendications**

1. Dérivés d'acylphosphines de formule générale

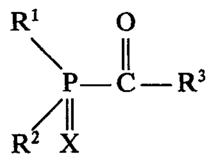

(I)

où les substituants ont les significations suivants:

$R^1$ est identique à $R^4$ ou $OR^4$

$R^2$ représente les groupements $-O^-M^+$ ou $-NR^5R^6$, $M^+$ signifiant un équivalent d'un cation du 1er au 3ème groupe principal du tableau périodique, d'un poids atomique inférieur à 138 ou les ions ammonium

$${}^{\oplus}NR^5R^6R^7R^8 \quad (II)$$

ou

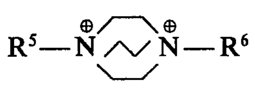

(II')

$R^5$ à $R^8$ étant identiques ou différents et représentant l'hydrogène, un reste alkyle à chaîne droite ou ramifiée, ayant jusqu'à 18 atomes C, qui peuvent être substitués éventuellement par un groupe hydroxyle, ou représentant un reste cyclohexyle, cyclopentyle, allyle ou phényle ou le groupe $\beta$-(méth)acryloxyéthyle, ou, dans la formule (II), deux de ces substituants formant avec l'azote un noyau à 5 à 7 chaînons, qui peut éventuellement contenir un atome d'oxygène ou un autre atome d'azote,

$R^3$ est un reste phényle, naphtyle, piridyle, pyrrolyle, furyle ou thiényle substitué qui porte, au moins sur les deux atomes de carbone voisins du point de liaison avec le groupe carbonyle, des substituants qui peuvent être identiques ou différents, et qui peuvent être des restes alkyle, alcoxy, ou alkylthio à chaîne droite ou ramifiée et contenant jusqu'à 6 atomes de carbone, des restes cycloalkyle ou phényle contenant jusqu'à 7 atomes de carbone, des groupes nitrile, carboxyle, carboalcoxy ou les atomes d'halogène, fluor, chlore ou brome,

$R^4$ représente hydrogène, un reste alkyle ou alcényle à chaîne droite ou ramifiée, avec jusqu'à 8 atomes de carbone, qui peut être éventuellement substitué par le groupement $-NR^5R^6$, le reste cyclohexyle ou cyclopentyle ou un reste phényle éventuellement substitué jusqu'à trois fois, les substituants pouvant être des groupes alkyle, alcoxy, alkylthio ou $NR^5R^6$ à chaîne droite ou ramifiée contenant jusqu'à 6 atomes de carbone, ou les atomes d'halogène, fluor, chlore ou brome,

X représente oxygène ou soufre ou signifie une paire d'électrons libre sur le phosphore.

2. Dérivés d'acylphosphines selon la revendication 1, caractérisés par le fait que X représente oxygène.

3. Dérivés d'acylphosphines selon la revendication 1, caractérisés par le fait que $R^3$ est un reste 2,6-diméthylphényle, 2,4,6-triméthylphényle, 2,3,6-triméthylphényle, 2,6-diméthoxyphényle, 2,6-dichlorophényle, 2,6-bis(méthylthio)-phényle, un reste 2,3,5,6-tétraméthylphényle, un reste 2,6-diméthyl-4-tert.-butylphényle, un reste 2,4,6-triméthylpyridyle-3, un reste 2,4-diméthylthiényle-3, un reste 1,3-diméthylnaphtalène-2 ou un reste 1,3-diméthoxynaphtalène-2.

4. Dérivés d'acylphosphines selon la revendication 3, caractérisés par le fait que $R^1$ représente un groupe phényle éventuellement substitué une à trois fois.

5. Utilisation des dérivés d'acylphosphines selon les revendivations 1 à 4 comme photoinitiateurs en masses photopolymérisables.

6. Utilisation des dérivés d'acylphosphines selon la revendication 5 en combinaison avec des amines secondaires ou tertiaires.

7. Utilisation des dérivés d'acylphosphines selon les revendications 1 à 4 comme photoinitiateurs dans les revêtements, vernis, encres d'impression et matériaux d'enregistrement photopolymérisables, ceux-ci contenant le photoinitiateur en une concentration de 0,01 à 10%.

8. Utilisation selon la revendication 5 ou 6 pour la préparation de masses de matières plastiques à base de résines polyesters, qui contiennent éventuellement d'autres produits auxiliaires, en particulier des fibres de verre et/ou des charges.

9. Utilisation selon les revendications 5 à 8, caractérisée par le fait que l'on utilise, comme photoinitiateurs, des dérivés d'acylphosphines de formule générale (I) en combinaison avec des composés du groupe des benzilacétals benzoinéthers, benzoinesters, thioxanthones substitués par alkyle en $C_1$ à $C_4$, chlore ou chlorométhyle, disulfures aromatiques, sulfochlorure de naphtalène, acylphosphines, acylphosphinoxydes, esters d'acides acylphosphiniques et sulfures d'acylphosphines.

10. Utilisation des dérivés d'acylphosphines selon les revendications 5 à 8, caractérisée par le fait que les dérivés d'acylphosphines sont utilisés en combinaison avec des initiateurs pour la polymérisation thermique.

11. Utilisation des composés selon les revendications 1 à 4, comme initiateurs pour la photopolymérisation de mélanges photopolymérisables qui contiennent de l'eau.

12. Utilisation selon la revendication 11 pour la préparation de dispersions ou solutions aqueuses de polymérisats.